# EUROPÄISCHE PATENTSCHRIFT

(11) **EP 1 128 442 B1**
(45) Veröffentlichungstag und Bekanntmachung des Hinweises auf die Patenterteilung: **27.08.2008**
(21) Anmeldenummer: 00122961.6
(22) Anmeldetag: 23.10.2000
(51) Int. Cl.: H01L 29/74, H01L 27/02

(54) **Laterale Thyristorstruktur zum Schutz vor elektrostatischer Entladung**
Lateral thyristor structure for protection against electrostatic discharge
Sructure de thyristor latéral pour protection contre les décharges électrostatiques

(30) Priorität: 10.02.2000 DE 10005811
(43) Veröffentlichungstag der Anmeldung: 29.08.2001
(73) Patentinhaber: Micronas GmbH, 79108 Freiburg i. Br. (DE)
(72) Erfinder: Czech, Martin, Dipl.-Ing., 79117 Freiburg (DE); Kessel, Jürgen, 79102 Freiburg (DE); Wagner, Eckart, 79279 Vörstetten (DE); Theus, Ulrich, 79194 Gundelfingen (DE)
(74) Vertreter: Patentanwälte Westphal, Mussgnug & Partner

(56) Entgegenhaltungen:
- WO-A-00/08688
- WO-A-90/14691
- US-A- 5 455 436
- US-A- 5 903 420
- US-A- 5 903 424
- US-A- 5 905 288

## Beschreibung

Die Erfindung betrifft eine laterale Thyristorstruktur zum Schutz vor elektrostatischer Entladung.

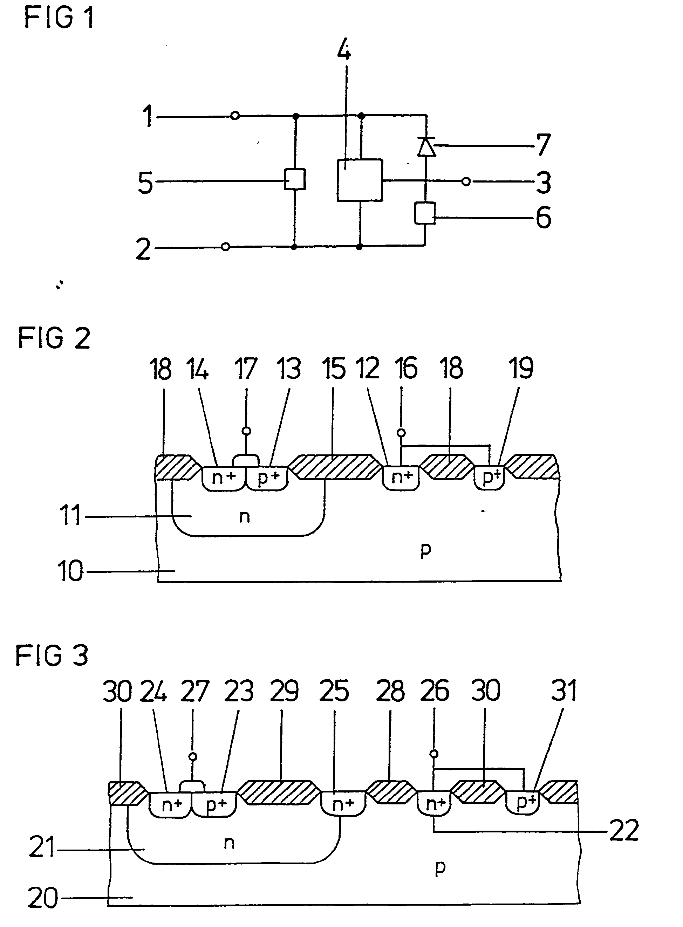

Integrierte Schaltkreise haben, wie in Figur 1 gezeigt, mindestens eine zu schützende innere Schaltung 4, zwei Versorgungsanschlüsse 1, 2 sowie einen Anschluss 3 für Eingang oder Ausgang. Im Falle einer elektrostatischen Entladung (ESD) in den Eingang/Ausgang kann eine sehr hohe Spannung / ein sehr starker Strom auf die Funktionselemente der inneren Schaltung 4 gelangen. Hiervon betroffen sind z. B. Gate-Oxide oder die Diffusionen von Ausgangstransistoren.

Außerdem kann die Entladung über immer vorhandene bipolare parasitäre Elemente auch die Versorgungsleitungen (1, 2) erreichen. In beiden Fällen können irreversible Schäden an der integrierten Schaltung entstehen. Üblicherweise werden daher Klemmvorrichtungen 5 an den Versorgungsanschlüssen 1, 2 angebracht, die die Versorgungsleitungen und die damit verbundenen Elemente schützen sollen. Zum Teil verfügen integrierte Schaltungen durch inhärente parasitäre bipolare Elemente über einen gewissen Selbstschutz, der jedoch meist nicht ausreichend ist.

Speziell bei Schaltungen, die mit hohen Versorgungsspannungen (z.B. 8V) arbeiten und die deshalb spezielle Hochvolttransistoren mit Driftzone aufweisen, triggern die inhärenten parasitären Elemente jedoch spät oder gar nicht. Eine Eigenschutzwirkung ist daher praktisch nicht vorhanden und es können Schäden durch ESD in dem Eingang/Ausgang 3 auftreten.

Aus diesem Grund wird - wie beispielsweise in der deutschen Offenlegungsschrift DE 41 35 522 gezeigt - eine Klemmschaltung 6 am Eingang/Ausgang zur Klemmung gegen eine Versorgungsleitung 2 hinzugefügt, die bei einer elektrostatischen Entladung (ESD) die Spannung am Eingang/Ausgang auf verträgliche Werte reduziert und die Entladung ableitet. Zudem erfolgt in der Regel auch eine Klemmung beispielsweise mittels einer Diode 7 gegen den anderen Versorgungsanschluss 1. Es kommt für die meisten Eingang/Ausgang-Schaltungen nur ein Parallelschutz in Frage, da in der Regel kein Serienwiderstand eingefügt werden darf. Als Schutzelemente finden dabei Thyristoren, Feld-Oxid-Transis-toren oder Dioden Anwendung.

Bei Dioden ist jedoch problematisch, dass die Spannung an der Diode bei hohen Strömen recht gross werden kann, insbesondere in Sperrrichtung, wodurch empfindliche Gate-Oxide und Diffusionen der zu schützenden inneren Schaltung beschädigt werden können. Darüber hinaus sind Dioden aufgrund ihres grossen Flächenbedarfs insbesondere bei integrierten Schaltkreisen mit mehreren Eingängen und/oder Ausgängen sehr ungünstig.

Die Offenlegungsschrift US 5,903,424 zeigt eine laterale Thyristorstruktur zum Schutz vor elektrostatischer Entladung.

Feld-Oxid-Transistoren können die Spannung zwar relativ gut klemmen, je nach der externen oder internen Beschaltung des Eingang/Ausgangs kann es aber vorkommen, dass der Feld-Oxid-Transistor in der Awendungsschaltung nach dem Zünden in einem sehr niederohmigen Zustand bei mittlerer Spannung verbleibt, wodurch der Eingang/Ausgang in seiner Funktion gestört wird. Kann beispielsweise eine externe Quelle einen ausreichenden Strom bei hoher Spannung liefern, dann kann es vorkommen, dass ein Transient am Eingang/Ausgang das Klemmelement zuendet und dieses aufgrund der "weichen Zündcharakteristik" einer Feld-Oxid-Transistorstruktur nicht mehr verlischt. Damit wird aber die Funktion der Schaltung so gestört, dass nur noch Ausschalten und nachfolgendes Einschalten die Feld-Oxid-Transistorstruktur löschen und damit die ursprüngliche Funktionsfähigkeit der Schaltung wieder herstellen kann.

Thyristoren ohne jede besondere Zündmassname ziehen im eingeschalteten Zustand so viel Strom ("harte Zündcharakteristik"), dass die externe/interne Quelle stark belastet wird und der Thyristor aufgrund des Spannungseinbruchs der Quelle auf jeden Fall verlischt. Allerdings wird die Schutzwirkung durch eine relativ hohe Zündspannung begrenzt, so dass Beschädigungen der Schaltung vor Erreichen der Zündspannung durchaus möglich sind.

Ein spezieller Hochvolt-Thyristor mit Hochvolt-Transistor als Zündelement schliesslich klemmt zwar auch die Spannung auf so niedrige Werte, dass keine sinnvolle Aussen/Innenbeschaltung ein "Hängenbleiben" verursachen kann. Allerdings zündet ein Hochvolt-Transistor als Zündelement aufgrund der Driftzone so spät, dass empfindliche Strukturen bereits beschädigt sein können.

Aufgabe der vorliegenden Erfindung ist es daher, eine Thyristorstruktur zum Schutz vor elektrostatischer Entladung anzugeben, die eine niedrigere Zündspannung aufweist und außerdem nicht im eingeschalteten Zustand hängenbleiben kann.

Die Aufgabe wird durch eine Thyristortruktur gemäss Patentanspruch 1 gelöst. Ausgestaltungen und Weiterbildungen des Erfindungsgedankens sind Gegenstand von Unteransprüchen.

Vorteil der Erfindung ist es , dass mit geringem Aufwand der Konflikt zwischen Zündverhalten einerseits und Ausschaltverhalten andererseits ausgeräumt wird, wobei erfindungsgemäss ein Feldoxid-Transsitor mit seinem günstigen Einschaltverhalten und ein Thyristor mit seinem günstigen Ausschaltverhalten kombiniert werden.

Erreicht wird dies im einzelnen insbesondere durch eine Thyristorstruktur zum Schutz vor elektrostatischer Entladung, welche ein Halbleitersubstrat von einem ersten Leitfähigkeitstyp mit einer Oberfläche und einen Wannenbereich von einem zweiten dem ersten entgegengesetzten Leitfähigkeitstyp, der in die Oberfläche des Halbleitersubstrats eingebracht ist, aufweist. Des weiteren ist ein erstes stark dotiertes Gebiet vom zweiten Leitfähigkeitstyp in die Oberfläche des Halbleitersubstrats eingebracht und mit einem ersten Anschluss elektrisch verbunden. Ein zweites stark dotiertes Gebiet vom ersten Leitfähigkeitstyp ist in den Wannenbereich eingebracht und mit einem zweiten Anschluss elektrisch verbunden. Ein drittes stark dotiertes Gebiet vom zweiten Leitfähigkeitstyp ist in den Wannenbereich eingebracht und mit dem zweiten Anschluss elektrisch verbunden, wobei es räumlich zwischen dem ersten stark dotierten Gebiet und dem zweiten stark dotierten Gebiet angeordnet ist. Schliesslich ist ein viertes stark dotiertes Gebiet vom zweiten Leitfähigkeitstyp vorgesehen, das in die Oberfläche des Halbleitersubstrats und in den Wannenbereich eingebracht ist und räumlich über dem zwischen dem Halbleitersubstrat und dem Wannenbereich gebildeten pn-Übergang und zwischen dem dritten stark dotierten Gebiet und dem ersten stark dotierten Gebiet angeordnet ist.
Die Thyristorstruktur weist mindestens zwei Teilstrukturen auf, die Teilstrukturen sind an den ersten Anschluss gespiegelt und die Teilstrukturen sind symmetrisch angeordnet.

In der vorliegenden Erfindung werden mehrere, vorzugsweise zwei, laterale Thyristorstrukturen nebeneinander in das Halbleitersubstrat integriert, vorzugsweise umgeben von einem Substratkontaktring. Vorzugsweise werden dann die zweiten stark dotierten Gebiete vom ersten Leitfähigkeitstyp, die in die Wannenbereiche eingebracht sind, nach aussen gesetzt, so dass das Halbleitersubstrat rings um die lateralen Thyristorstrukturen auf definiertem Potential gehalten werden. Dadurch wird ein wirksamer "Latch-up"-Schutz erzielt. Damit ist gemeint, dass die Umgebung der lateralen Thyristorstrukturen vor einem ungewollten Zünden geschützt wird.

Außerdem sind die Thyristoren so besser miteinander verkoppelt, was ein einseitiges Ausschalten verhindert, was die Ausschaltproblematik wesentlich entschärft, und so der Strombedarf der Struktur im eingeschalteten Zustand immer maximal bleibt.

Da die erfindungsgemässe laterale Thyristorstruktur zum Schutz vor elektrostatischer Entladung eine Zündspannung von ungefähr 12 Volt aufweist, wird ein wirksamer Schutz auch für VLSI-Schaltungen in CMOS-Technologie erzielt, bei denen sehr dünne Gateoxide und kurze Kanallängen in den Transistoren vorliegen.

Diese niedrigere Zündspannung von ungefähr 12 Volt wird dadurch erzielt, dass das elektrische Feld zwischen dem vierten stark dotierten Gebiet vom zweiten Leitfähigkeitstyp, das in die Oberfläche des Halbleitersubstrats und in den Wannenbereich eingebracht ist, und dem Halbleitersubstrat höher ist als das elektrische Feld zwischen dem Wannenbereich und dem Halbleitersubstrat. Dadurch kommt es zu einem Lawinendurchbruch zwischen dem vierten stark dotierten Gebiet, das in die Oberfläche des Halbleitersubstrat und in den Wannenbereich eingebracht ist und dem Halbleitersubstrat. Die vom Lawinendurchbruch generierten Ladungsträger steuern dabei die Basis eines npn-Transistors auf, wobei der npn-Transistor aus dem ersten stark dotierten Gebiet vom zweiten Leitfähigkeitstyp, dem Halbleitersubstrat und dem Wannenbereich gebildet wird. Der Wannenbereich bildet bei dem npn-Transistor den Kollektor, das Halbleitersubstrat bildet die Basis und das erste stark dotierte Gebiet bildet den Emitter. Durch das Aufsteuern der Basis durch die durch den Lawinendurchbruch generierten Ladungsträger wird der npn-Transistor eingeschaltet, so dass ein Stromfluss von der Anode zur Kathode in der lateralen Thyristorstruktur stattfindet.

Die erfindungsgemässe laterale Thyristorstruktur zum Schutz vor elektrostatischer Entladung kann problemlos in die derzeit verfügbaren CMOS-Prozesse eingebunden werden. Das heisst, dass ohne grosse Abänderung, insbesondere ohne weitere Masken und Spezialschritte, die laterale Thyristorstruktur in einen CMOS-IC monolithisch integriert werden kann. Es ist jedoch aber auch denkbar, die laterale Thyristorstruktur in andere Halbleiterschaltungen, die aus anderen Prozessen hervorgegangen sind, zu integrieren. Denkbar wären dabei BiCMOS-Prozesse, verschiedene Prozesse der Leistungshalbleiter sowie verschiedene DRAM-Prozesse.

Vorzugsweise sind demnach zwischen dem ersten stark dotierten Gebiet und dem vierten stark dotierten Gebiet sowie zwischen dem zweiten stark dotierten Gebiet und dem vierten stark dotierten Gebiet Feldoxidbereiche angeordnet, wie sie bei CMOS-Techniken üblich sind. Diese Feldoxidbereiche werden in CMOS-Technologien durch thermische Oxidation von Silizium erzeugt. Dabei setzt man die Oberfläche des Halbleitersubs-trats in einem Ofen bei ca. 1000°C einem Strom reinen Sauerstoffgases oder aber inerten Stickstoffgases mit einem Anteil an Wasserdampf aus.

Eine weitere Fortbildung besteht im Vertauschen von Gebiet 23 und 24, wodurch sich ein anderes Zündverhalten (später) und Abschaltverhalten ergibt (mehr Strombedarf).

Es kann zudem vorgesehen werden, dass in einen Feldoxidbereich ein mit einem Anschluss versehener Bereich vom zweiten Leitungstyp eingebracht ist, wobei der Anschluss mit der zu schützenden Schaltung verbunden ist.

Die Erfindung wird nachfolgend anhand der in den Figuren der Zeichnung dargestellten Ausführungsbeipiele näher erläutert. Es zeigen:
- Figur 1: eine Schaltungsanordnung zum Schutz vor elektrostatischer Entladung,
- Figur 2: einen Schnitt durch eine laterale Thyristorstruktur zum Schutz vor elektrostatischer Entladung nach dem Stand der Technik,
- Figur 3: einen Schnitt durch eine unsymmetrische laterale Thyristorstruktur zum Schutz vor elektrostatischer Entladung nicht gemäss der vorliegenden Erfindung.
- Figur 4: einen Schnitt durch eine symmetrische laterale Thyristorstruktur zum Schutz vor elektrostatischer Entladung gemäss der vorliegenden Erfindung,
- Figur 5: einen Schnitt zu einer zu Figur 3 alternativen unsymmetrischen lateralen Thyristorstruktur zum Schutz vor elektrostatischer Entladung micht gemäss der vorliegenden Erfindung,
- Figur 6: eine Anwendung der Thyristorstruktur nach Figur 5 bei einer Schaltungsanordnung zum Schutz vor elektrostatischer Entladung gemäss Figur 1 und
- Figur 7: einen Schnitt zu einer zu Figur 3 weiteren alternativen unsymmetrischen lateralen Thyristorstruktur zum Schutz vor elektrostatischer Entladung nicht gmäss der vorliegenden Erfindung.

Die Figur 2 zeigt schematisch einen Schnitt durch eine laterale Thyristorstruktur zum Schutz vor elektrostatischer Entladung, wie sie beispielsweise aus R. N. Rountree et al. "A Process-Tolerant Input Protection Circuit for Advanced CMOS-Processes", 1988, EOS/ESD-Symposium Proceedings, Seiten 201 bis 205 bekannt ist.

Die laterale Thyristorstruktur ist in ein Halbleitersubstrat 10 integriert. Das Halbleitersubstrat 10 ist schwach p-dotiert. Das schwach p-dotierte Halbleitersubstrat 10 ist elektrisch mit einer Kathode 16 verbunden über den Substratkontakt 19, einen stark p-dotierten Bereich. In das schwach p-dotierte Halbleitersubstrat 10 ist ein Wannenbereich 11 eindiffundiert, der schwach n-dotiert ist.

In die Oberfläche des schwach p-dotierten Halbleitersubstrats 10 ist ein erstes stark n-dotiertes Gebiet 12 eindiffundiert, das ebenfalls mit der Kathode 16 verbunden ist.

Ein stark p-dotiertes Gebiet 13 und ein stark n-dotiertes Gebiet 14 sind in die Oberfläche des schwach n-dotierten Wannenbereichs 11 eindiffundiert. Das stark p-dotierte Gebiet 13 und das stark n-dotierte Gebiet 14 sind beide mit einer Andode 17 elektrisch verbunden.

Im gezeigten Stand der Technik grenzen das stark p-dotierte Gebiet 13 und das stark n-dotierte Gebiet 14 direkt aneinander an. Es ist jedoch auch möglich, dass das stark p-dotierte Gebiet 13 und das stark n-dotierte Gebiet 14 räumlich beispielsweise über einen Feldoxidbereich voneinander getrennt sind (nicht gezeigt). Zwischen das erste stark n-dotierte Gebiet 12 und das stark p-dotierte Gebiet 13 ist ein Feldoxidbereich 15 angeordnet. Der Feldoxidbereich 15 ist räumlich über dem pn-Übergang angeordnet, der zwischen dem schwach n-dotierten Wannenbereich 11 und dem schwach p-dotierten Halbleitersubstrat 10 gebildet wird. Die laterale Thyristorstruktur wird schliesslich von Feldoxidbereichen 18 von weiteren, nicht gezeigten Halbleiterstrukturen, die in das Halbleitersubstrat 10 eingebracht sind und die zu schützende Schaltung bilden, räumlich getrennt.

Das stark n-dotierte Gebiet 12 bildet den Emitter eines pnp-Transistors. Das schwach p-dotierte Halbleitersubstrat 10 bildet die Basis dieses npn-Transistors. Der schwach n-dotierte Wannenbereich 11 schliesslich bildet den Kollektor eines npn-Transistors. Das schwach p-dotierte Halbleitersubstrat 10 bildet ferner den Kollektor eines pnp-Transistors. Der schwach n-dotierte Wannenbereich bildet wiederum die Basis für diesen pnp-Transistor. Letztendlich bildet das stark p-dotierte Gebiet 13 den Emitter dieses pnp-Transistors.

Wenn eine Spannung zwischen der Anode 17 und der Kathode 16 anliegt, die kleiner ca. 50 Volt beträgt, ist der pn-Übergang zwischen dem schwach n-dotierten Wannenbereich 11 und dem schwach p-dotierten Halbleitersubstrat 10 gesperrt, so dass die laterale Thyristorstruktur nur einen sehr kleinen Strom leitet. Überschreitet jedoch die Spannung ungefähr 50 Volt zwischen Anode 17 und Kathode 16, so kommt es zum Lawinendurchbruch, so dass Ladungsträger am pn-Übergang zwischen den schwach n-dotierten Wannenbereich 11 und dem schwach p-dotierten Halbleitersubstrat 10 generiert werden.

Durch diesen Lawinendurchbruch werden Ladungsträger an den Basis-Kollektor-Übergängen der beiden Bipolartransistoren, nämlich dem npn-Transistor einerseits und dem pnp-Transistor andererseits generiert, so dass der laterale Thyristor zündet.

Die Figur 3 zeigt eine laterale Thyristorstruktur zum Schutz vor elektrostatischer Entladung Die laterale Thyristorstruktur ist in ein schwach p-. Die laterale Thyristorstruktur ist in ein schwach p-dotiertes Halbleitersubstrat 20 in dessen Oberfläche eingebracht. Das schwach p-dotierte Halbleitersubstrat 20 ist mit der Kathode 26 über den Substratkontaktring 31, einen stark p-dotierten Bereich, elektrisch leitend verbunden. Ein schwach n-dotierter Wannenbereich 21 ist in die Oberfläche des schwach p-dotierten Halbleitersubstrats 20 eindiffundiert. Ferner ist ein stark n-dotierter Bereich 22 in die Oberfläche des schwach p-dotierten Halbleitersubstrats 20 eindiffundiert und ebenfalls elektrisch mit der Kathode 26 verbunden. Des Weiteren sind ein stark p-dotierter Bereich 23 und ein stark n-dotierter Bereich 24 in den schwach n-dotierten Wannenbereich 21 eindiffundiert und beide elektrisch mit der Anode 27 verbunden.

Der stark p-dotierte Bereich 23 und der stark n-dotierte Bereich 24 liegen in dem schwach n-dotierten Wannenbereich 21 direkt nebeneinander. Es ist jedoch auch denkbar, dass der stark p-dotierte Bereich 23 und der stark n-dotierte Bereich 24 in dem schwach n-dotierten Wannenbereich 21 räumlich beispielsweise durch einen Feldoxidbereich voneinander getrennt sind (nicht gezeigt).

Das schwach p-dotierte Halbleitersubstrat 20 weist ferner einen Feldoxidbereich 28 auf, der zwischen dem stark n-dotierten Bereich 22 und einem stark n-dotierten Bereich 25 angeordnet ist. Der stark n-dotierte Bereich 25 ist in die Oberfläche des Halbleitersubstrats 20 und in den Wannenbereich 21 eingebracht und räumlich über dem zwischen dem schwach p-dotierten Halbleitersubstrat 20 und dem schwach n-dotierten Wannenbereich 21 gebildeten pn-Übergang angeordnet. Das stark n-dotierte Gebiet 25 kann dabei eindiffundiert oder mittels Ionenimplantation eingebracht sein.

Ein weiterer Feldoxidbereich 29 ist zwischen dem stark n-dotierten Gebiet 25 und dem stark p-dotierten Gebiet 23 in die Oberfläche des stark n-dotierten Wannenbereichs angeordnet. Die gesamte laterale Thyristorstruktur wird schliesslich begrenzt von Feldoxidbereichen 30, die die laterale Thyristorstruktur von anderen in das Halbleitersubstrat 20 integrierten Schaltungsbestandteilen räumlich trennt.

Das stark n-dotierte Gebiet 22 bildet den Emitter eines npn-Transistors dessen Basis das schwach p-dotierte Halbleitersubstrat 20 bildet. Den Kollektor dieses npn-Transistors bildet der schwach n-dotierte Wannenbereich 21. Ferner liegt in der in Figur 3 gezeigten lateralen Thyristorstruktur ebenfalls ein pnp-Transistor vor. Die Basis dieses pnp-Transistors wird durch den schwach n-dotierten Wannenbereich 21 gebildet. Der Kollektor des pnp-Transistors wird durch das schwach p-dotierte Halbleitersubstrat 20 gebildet und der Emitter des pnp-Transistors wird durch das stark p-dotierte Gebiet 23 gebildet. Beide Bipolartransistoren weisen ebenfalls parasitäre Basiswiderstände auf, die durch das schwach p-dotierte Halbleitersubstrat 20 einerseits und den schwach n-dotierten Wannenbereich 21 andererseits gebildet werden.

Im Vergleich zu der in Figur 2 gezeigten lateralen Thyristorstruktur weist die in der Figur 3 gezeigte laterale Thyristorstruktur eine wesentlich verringerte Zündspannung für den Thyristor auf, da das elektrische Feld zwischen dem stark n-dotierten Gebiet 25 und dem schwach p-dotierten Halbleitersubstrat 20 wesentlich höher ist als das elektrisch Feld zwischen dem schwach n-dotierten Wannenbereich 21 und dem schwach p-dotierten Halbleitersubstrats 20. Durch diese Massnahme kann ein Lawinendurchbruch zwischen dem stark n-dotierten Gebiet 25 und dem schwach p-dotierten Halbleitersubstrat 20 wesentlich einfacher erzeugt werden, als im Stand der Technik nach Figur 2.

Der Lawinendurchbruch erzeugt Ladungsträger zwischen dem stark n-dotierten Gebiet 25 und dem schwach p-dotierten Halbleitersubstrat 20, die die Basis den npn-Transistors aufsteuern, so dass der npn-Transistor eingeschaltet wird und Strom durch die laterale Thyristorstruktur von der Anode 27 zur Kathode 26 zu fliessen beginnt.

Die Zündspannung der erfindungsgemässen und in Figur 3 gezeigten lateralen Thyristorstruktur ist demnach im wesentlichen auf die "Zündspannung" des npn-Transistors reduziert, der aus dem stark n-dotierten Gebiet 25, dem schwach p-dotierten Halbleitersubstrat und dem stark n-dotierten Gebiet 22 gebildet wird.

Eine weitere Ausführung liegt im Vertauschen der Gebiete 23 und 24. Dadurch verändert sich die Charakteristik des PNP-Transistors 23, 21, 20, indem die effektive Basisweite vergrößert wird, außerdem kommt 24 näher an die elektronisch aktive Zone, dadurch wird also der Basisbahnwiderstand kleiner. Das Einschalten des Thyristors kann also verzögert werden, bzw. das Ausschalten erleichtert. Die Vertauschung stellt also eine weitere Möglichkeit zur Optimierung dar, ohne jegliche Mehrkosten.

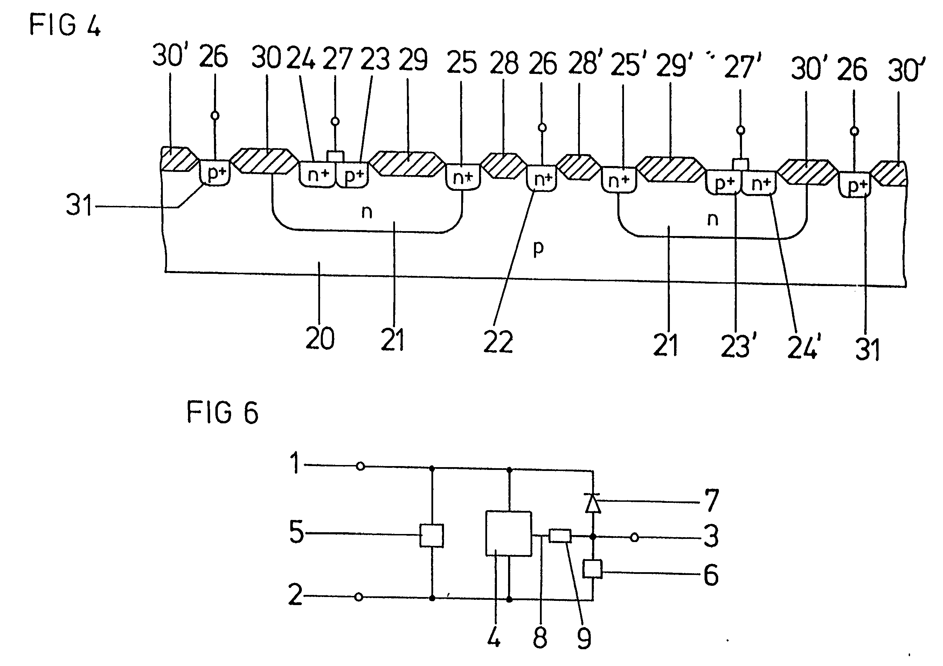

Gegenüber Figur 3 ist das Ausführungsbeispiel nach Figur 4 dahingehend gebildet, dass anstelle eines unsymmetrischen Aufbaus ein symmetrischer gewählt wurde, wodurch unerwünschte Randeffekte vermieden werden. Es wird somit vermieden, dass beim Ausschalten einer der Teilthyristoren alleine "hängen" bleibt, dies wäre problematisch, da ein einzelner Teilthyristor nur wenig Haltestrom benötigt. Dies wird insbesondere dadurch erreicht, dass die aktiven Gebiete der Thyristoren vom Rand besser entkoppelt und einander enger benachbart sind. Geht man von der Struktur in Figur 3 aus, dann wird diese zur Symmetrierung beispielsweise an der Kathode gespiegelt und es ergeben sich zwei im wesentlichen identische, zueinander spiegelverkehrte Strukturen in dem schwach p-dotierten Halbleitersubstrat 20. Folglich ergeben sich in entprechender Weise bei der "duplizierten" Struktur ebenfalls ein schwach n-dotierter Wannenbereich 21', ein stark p-dotierter Bereich 23', ein stark n-dotierter Bereich 24', ein stark n-dotierter Bereich 25', eine Anode 27' sowie Feldoxidbereiche 28', 29' und 30'. Ausserdem ist die Struktur von einem stark p-dotierten Substratkontaktring 31 ("Rand") mit Anoden-Anschluss 26 umgeben, um beim Zünden im Betrieb nicht die gesamte Umgebung in einen Latch-Up-Zustand zu bringen. Selbstverständlich kann man auch mehr als zwei Thyristoren kombinieren, wobei für eine symmetrische Ausbildung der Struktur geradzahlige Vielfache zur Anwendung kommen.

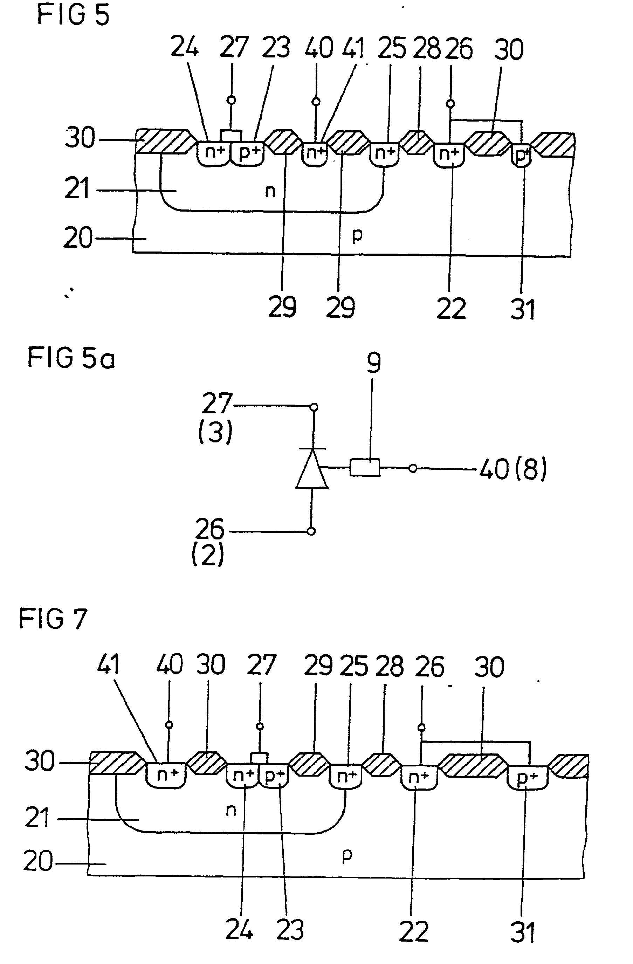

Das Ausführungsbeispiel nach Figur 5 geht aus der in Figur 3 gezeigten Ausführungsform dadurch hervor, dass in den Feldoxidbereich 29 ein stark n-dotiertes Gebiet 41 eingebracht, der den Feldoxidbereich 29 in zwei Teilbereiche aufteilt, wobei dazwischen das stark n-dotierte Bereich 20 angeordnet ist. Als Ersatzschaltbild einer derartigen Struktur ergibt sich in Figur 5a ein Thyristor, der eine Anode 26, eine Kathode 27 sowie einen internen Anschluss 40 mit einem Widerstand 9 aufweist. Dabei ist der interne Anschluss 40 neben dem Widerstand 9 durch Diffusion und/oder Implantation in den Thyristor 42 integriert.

Bei der Schaltung nach Figur 1 liegt ein Eingangssignal (Anschluss 3) an der Diode 7 und an der Klemmschaltung 6 (Thyristor) an und geht dann über einen metallische Verbindung zur inneren Schaltung 4. Das Bondpad ist folglich metallisch mit der inneren Schaltung 4 verbunden. Dies birgt jedoch Gefahren in sich, denn in der Regel kann das Bondpad schon grosse Spannungen erreichen, bevor die Schutzstruktur nach einer Verzögerungszeit aktiv wird. Alternativ wird gemäss Figuren 5 und 6 der Signalpfad in den Thyristor verlegt und es ergibt sich somit ein tolerierbarer Serienwiderstand 9, der ausgehend von Figur 1 zwischen der entsprechenden Anschlussleitung 8 der inneren Schaltung 4 und Eingang/Ausgang 3 geschaltet ist (Figur 6). Damit "sieht" die innere Schaltung 4 nie direkt die Spannung am Eingang/Ausgang 3, sondern nur die Spannung am Thyristor. Dies bringt eine erhebliche Verbesserung des Schutzes der inneren Schaltung 4 bei ESD-Transienten.

In Figur 7 ist schliesslich eine Ausführungsform einer Thyristorstruktur gezeigt, die insbesondere für Anwendungen geeignet ist, bei denen über die Anschlussleitung 8 in Figur 6 ein grosser Strom fliesst, wodurch es zu unerwünschtem Einschalten beziehungsweise zu Problemen beim Ausschalten kommen könnte. Gegenüber der Ausführungsform nach Figur 5 ist beim Ausführungsbeispiel 7 der Anschluss 40 so verschoben, dass zwar die Schutzwirkung erhalten bleibt, jedoch die hohen Ströme auf der Anschlussleitung 8 in Figur 6 jedoch nicht in kritischen Bereichen des Thyristors fliessen, also nicht zwischen Anode 26 und Kathode 27. Der Anschluss 40 samt dem stark n-dotierten Gebiet 41 ist im Hinblick auf Figur 3 demnach beispielsweise in den Feldoxidbereich 30 eingebracht anstelle des Feldoxidbereichs 29 bei Figur 5.

Die gezeigte erfindungsgemässe laterale Thyristorstruktu-re vereint demnach in sehr vorteilhafter Weise die hohe Stromtragfähigkeit eines Thyristors mit der niedrigen "Zündspannung" eines Feldoxid-Bipolartransistors.

Selbstverständlich können bei den gezeigten und diskutierten Strukturen alle n-Leitfähigkeiten gegen p-Leitfähigkeiten und umgekehrt ausgetauscht werden, ohne das die Wirkungsweise und das Wirkungsprinzip der vorliegenden Erfindung beeinträchtigt wird. Sämtliche dotierten Gebiete 22, 23, 24 und 25, 31, 41 sowie der diskutierte Wannenbereich 21 können entweder über Diffusion in das Halbleitersubstrat 20 oder über Ionenimplantation eingebracht werden. Es sind Kombinationen aus Diffusionen und Implantationen denkbar, die ebenfalls die Wirkungsweise und das Wirkungsprinzip der vorliegenden Erfindung nicht beeinträchtigen.

## Patentansprüche

1. Laterale Thyristorstruktur zum Schutz vor elektrostatischer Entladung, bestehend aus: einer Teilstruktur, bestehend aus:
- einem Halbleitersubstrat (20) von einem ersten Leitfähigkeitstyp mit einer Oberfläche;
- einem Wannenbereicht (21) von einem zweiten, den ersten entgegengesetzten Leitfähigkeitstyp, der in die Oberfläche des Halbleitersubstrats eingebracht ist;
- einem ersten stark dotierten Gebiet (22) vom zweiten Leitfähigkeitstyp, das in die Oberfläche des Halbleitersubstrats (20) eingebracht ist und mit einem ersten Anschluss (26) elektrisch verbunden ist;
- einem zweiten stark dotierten Gebiet (23) von einem ersten Leitfähigkeitstyp, das in den Wannenbereich (21) eingebracht ist und mit einem zweiten Anschluss (27) elektrisch verbunden ist;
- einem dritten stark dotierten Gebiet (24) vom anderen zweiten Leitfähigkeitstyp, das in den Wannenbereich (21) eingebracht ist und mit dem zweiten Anschluss (27) elektrisch verbunden ist und wobei das zweite stark dotierte Gebiet (23) räumlich zweischen dem ersten stark dotiertenGebiet (22) und dem dritten stark dotierten Gebiet (24) angeordnet ist; und
- einem vierten stark dotierten Gebiet (25) vom zweiten Leitfähigkeitstyp, das in die Oberfläche des Halbleitersubstrates (20) und in den Wannenbereich (21) eingebracht ist und räumlich über dem zwischen dem Halbleitersubstrat (20) und dem Wannenbereich (21) gebildeten pn-Übergang und zwischen stark dotierten Gebiet (22) angeordnet ist,
**dadurch gekennzeichnet, dass** die Thyristorstrukturen mindestens zwei Teilstrukturen aufweist, und dass die Teilstrukturen symmetrisch angeordnet sind und dass die Teilstrukturen au dem ersten Anschluss gespiegelt sind.

2. Laterale Thyristorstruktur nach Anspruch 1,
**dadurch gekennzeichnet,dass**
zwischen dem ersten stark dotierten Gebiet (22) und dem vierten stark dotierten Gebiet (25) ein Feldoxidbereich (28) angeordnet ist.

3. Laterale Thyristorstruktur nach Anspruch 1 oder 2,
**dadurch gekennzeichnet, dass**
zwischen dem zweiten stark dotierten Gebiet (23) und dem vierten stark dotierten Gebiet (25) ein Feldoxidbereich (29) angeordnet ist.

4. Laterale Thyristorstruktur nach einem der Ansprüche 1 bis 3,
**dadurch gekennzeichnet, dass** der erste Leitfähigkeitstyp p-leitend ist und der zweiten Leitfähigkeitstyp n-leitend ist.

5. Laterale Thyristorstruktur nach einem der Ansprüche 1 bis 4,
**dadurch gekennzeichnet, dass**
der erste Anschluss mit Masse verbunden ist und dass der zweite Anschluss mit einer Signaleingangsleitung oder mit einer Signalausgangsleitung verbunden ist.

6. Laterale Thyristorstruktur nach einem der Ansprüche 1 bis 5,
**dadurch gekennzeichnet, dass**
in einen Feldoxidbereich (29, 30) ein mit einem Anschluss (40) versehener Bereich (41) vom zweiten Leitungstyp eingebracht ist, wobei der Anschluss (40) mit einer zu schützenden Schaltung (4) verbunden ist.

7. Laterale Thyristorstruktur nach einem der Ansprüche 1 bis 6,
**dadurch gekennzeichnet, dass**
die Teilstrukturen von einem Substratkontaktring (31) umgeben sind.

8. Laterale Thyristorstruktur nach einem der vorangehenden Ansprüche,
**dadurch gekennzeichnet, dass**
die aktiven Gebiete dicht benachbart sind, während der Substratkontaktierung möglichst weit vom aktiven Gebiet entfernt ist.

9. Laterale Thyristorstruktur nach einem der vorangehenden Ansprüche,
**dadurch gekennzeichnet,dass**
die aktiven Gebiete dicht benachbart sind, während der Substratkontaktring möglichst weit vom aktiven Gebiet entfernt ist.

10. Laterale Thyristorstruktur nach einem der vorangehenden Ansprüche,
**dadurch gekennzeichnet, dass**
die Gebiete 23 und 24 vertauscht sind.

## Claims

1. A lateral thyristor structure for protection against electrostatic discharge, consisting of:
a sub-structure consisting of:
- a semiconductor substrate (20) of a first conductivity type with a surface;
- a well area (21) of a second conductivity type opposite the first, which is introduced into the surface of the semiconductor substrate;
- a first strongly doped area (22) of the second conductivity type, which is introduced into the surface of the semiconductor substrate (20) and is electrically connected to a first terminal (26);
- a second strongly doped area (23) of a first conductivity type, which is introduced into the well area (21) and is electrically connected to a second terminal (27);
- a third strongly doped area (24) of the other second conductivity type, which is introduced into the well area (21) and is electrically connected to the second terminal (27) and wherein the second strongly doped area (23) is disposed spatially between the first strongly doped area (22) and the third strongly doped area (24); and
- a fourth strongly doped area (25) of the second conductivity type, which is introduced into the surface of the semiconductor substrate (20) and into the well area (21) and is disposed spatially above the pn junction formed between the semiconductor substrate (20) and the well area (21) and between strongly doped area (22),
**characterised in that** the thyristor structures comprise at least two sub-structures,
and **in that** the sub-structures are symmetrically disposed, **and in that** the sub-structures are reflected at the first terminal.

2. A lateral thyristor structure according to Claim 1, **characterised in that** a field oxide area (28) is disposed between the first strongly doped area (22) and the fourth strongly doped area (25).

3. A lateral thyristor structure according to Claim 1 or 2,
**characterised in that** a field oxide area (29) is disposed between the second strongly doped area (23) and the fourth strongly doped area (25).

4. A lateral thyristor structure according to one of Claims 1 to 3,
**characterised in that** the first conductivity type is p-conducting and the second conductivity type is n-conducting.

5. A lateral thyristor structure according to one of Claims 1 to 4,
**characterised in that** the first terminal is connected to earth
**and in that** the second terminal is connected to a signal input line or to a signal output line.

6. A lateral thyristor structure according to one of Claims 1 to 5,
**characterised in that** an area (41) of the second conductivity type and provided with a terminal (40) is introduced into a field oxide area (29, 30), the terminal (40) being connected to a circuit (4) to be protected.

7. A lateral thyristor structure according to one of Claims 1 to 6,
**characterised in that** the sub-structures are surrounded by a substrate contact ring (31).

8. A lateral thyristor structure according to one of the preceding Claims,
**characterised in that** the active areas are close together, whereas the substrate bond is as far way from the active area as possible.

9. A lateral thyristor structure according to one of the preceding Claims,
**characterised in that** the active areas are close together, whereas the substrate contact ring is as far away from the active area as possible.

10. A lateral thyristor structure according to one of the preceding Claims,
**characterised in that** the areas 23 and 23 are transposed.

## Revendications

1. Structure de thyristor latéral pour la protection contre les décharges électrostatiques comprenant une structure partielle ayant :
- un substrat semi-conducteur (20) d'un premier type de conductivité avec une surface supérieure
- une zone de cuvette (21) d'un second type de conductivité opposé au second type de conductivité, cette cuvette étant réalisée dans la surface du substrat semi-conducteur,
- une première zone (22) fortement dopée du second type de conductivité, réalisée dans la surface supérieure du substrat semi-conducteur (20) est reliée électriquement à un premier branchement (26),
- une seconde zone (23) fortement dopée d'un premier type de conductivité, réalisée dans la zone de cuvette (21) est reliée électriquement à un second branchement (27),
- une troisième zone (24) fortement dopée, d'un autre second type de conductivité, réalisée dans la zone de cuvette (21) est reliée électriquement au second branchement (27) et la seconde zone (23) fortement dopée, se situe dans l'espace entre la première zone fortement dopée (22) et la troisième zone fortement dopée (24) et
- une quatrième zone (25) fortement dopée du second type de conductivité, réalisée dans la surface supérieure du substrat semi-conducteur (20) et dans la zone de cuvette (21) en se situant dans l'espace au-dessus de la jonction pn formée entre le substrat semi-conducteur (20) et la zone de cuvette (21) et entre la zone (22) fortement dopée,
**caractérisée en ce que**
la structure de thyristor comporte au moins deux partie de structure et les parties de structure sont installées de manière symétrique et
les parties de structure sont en miroir par rapport au premier branchement.

2. Structure de thyristor latéral selon la revendication 1,
**caractérisée par**
une zone d'oxyde de champ (28) entre la première zone fortement dopée (22) et la quatrième zone fortement dopée (25).

3. Structure de thyristor latéral selon la revendication 1 ou 2,
**caractérisée par**
une zone d'oxyde de champ (29) prévue entre la seconde zone (23) fortement dopée et la quatrième zone (25) fortement dopée.

4. Structure de thyristor latéral selon l'une des revendications 1 à 3,
**caractérisée en ce que**
le premier type de conductibilité est la conductivité p et le second type de conductivité est la conductivité n.

5. Structure de thyristor latéral selon l'une des revendications 1 à 4,
**caractérisée en ce que**
le premier branchement est relié à la masse, et
le second branchement est relié à une ligne d'entrée de signal ou à une ligne de sortie de signal.

6. Structure de thyristor latéral selon l'une des revendications 1 à 5,
**caractérisée en ce qu'**
une région (41) d'un second type de conductivité est munie d'un branchement (40) et réalisée dans une zone d'oxyde de champ (29, 30), le branchement (40) étant relié à un circuit (4) à protéger.

7. Structure de thyristor latéral selon l'une des revendications 1 à 6,
**caractérisée en ce que**
les parties de structure sont entourées par un anneau de contact de substrat (31).

8. Structure de thyristor latéral selon l'une des revendications précédentes,
**caractérisée en ce que**
les régions actives sont étroitement rapprochées alors que le contact du substrat est éloigné aussi loin que possible de la région active.

9. Structure de thyristor latéral selon l'une des revendications précédentes,
**caractérisée en ce que**
les régions actives sont étroitement rapprochées alors que l'anneau de contact de substrat est éloigné aussi loin que possible des régions actives.

10. Structure de thyristor latéral selon l'une des revendications précédentes,
**caractérisée en ce que**
les régions (23) et (24) sont échangées.
